# EUROPEAN PATENT SPECIFICATION

(11) **EP 3 127 165 B1**
(45) Date of publication and mention of the grant of the patent: **12.08.2020**
(21) Application number: 15717751.0
(22) Date of filing: 06.04.2015
(51) Int. Cl.: H01L 31/0304, H01L 31/18, H01L 31/054

(54) **METHOD TO MANUFACTURE EPITAXIAL LIFT-OFF PROCESSED THIN-FILM SOLAR CELLS INTEGRATED WITH NON-TRACKING MINI-COMPOUND PARABOLIC CONCENTRATORS**
HERSTELLUNGSVERFAHREN FÜR EPITAKTISCHE BEARBEITETE LIFT-OFF-DÜNNSCHICHTSOLARZELLEN MIT NICHTVERFOLGENDEN MINI-VERBUNDPARABOLKONZENTRATOREN
PROCÉDÉ DE FABRICATION DE CELLULES SOLAIRES EN COUCHES MINCES TRAITÉES CONTRE LE DÉCOLLEMENT ÉPITAXIAL INTÉGRÉES AVEC DES MINI MIROIRS COMPOSÉS À FOYER QUASI-PONCTUEL SANS POURSUITE

(30) Priority: 04.04.2014 US 201461975623 P
(43) Date of publication of application: 08.02.2017
(73) Proprietor: The Regents Of The University Of Michigan, Ann Arbor, Michigan 48109 (US)
(72) Inventor: LEE, Kyusang, Ann Arbor, Michigan 48105 (US); FORREST, Stephen, R., Ann Arbor, Michigan 48104 (US)
(74) Representative: Finnegan Europe LLP
(86) International application number: PCT/US2015/024532
(87) International publication number: WO 2015/154080

(56) References cited:
- WO-A1-2011/049569
- WO-A2-2008/024201
- WO-A2-2013/006803
- US-A1- 2005 081 909
- CARVALHO M J ET AL: "Truncation of CPC solar collectors and its effect on energy collection", SOLAR ENERGY, PERGAMON PRESS. OXFORD, GB, vol. 35, no. 5, 1 January 1985 (1985-01-01), pages 393-399, XP025415960, ISSN: 0038-092X, DOI: 10.1016/0038-092X(85)90127-6 [retrieved on 1985-01-01]

## Description

The present disclosure generally relates to methods for making thin-film electronic and optoelectronic devices, such as flexible photovoltaic devices, using epitaxial lift-off (ELO). ELO is a technology in which a thin-film device region may be "lifted off" of a growth substrate or wafer and transferred to a host substrate. The device region is separated from the wafer by selectively etching a sacrificial layer. In particular, the disclosure relates to a method of manufacturing thin-film ELO cells bonded onto flexible substrates that provide a unique opportunity to integrate the solar collector with the thin-film cell.

ELO has yielded thin single crystalline GaAs solar cells with efficiencies of greater than 28%. While impressive, the process of using chemical etching of a "sacrificial layer" between the cell active layers and the substrate in ELO requires post-treatment of the parent wafer to ready it once more for epitaxial growth of another solar cell active region. For example, to eliminate these defects in preparation for subsequent epitaxial growth, a polishing etch process is typically used. Generally, however, this process does not provide a high quality regrowth interface, and thus device layers grown on a chemically polished surface after ELO lead to subsequently fabricated devices with dramatically reduced performance. Bauhuis, G.J. et al., "Wafer reuse for repeated growth of lll-V solar cells," Prof. Photovolt. 18, 155-159 (2010). Chemo-mechanical wafer repolishing is used to solve this problem, but such process consumes tens of microns of material from the top surface of the wafer, thereby limiting the potential number of wafer reuses.

Thus, the cost reduction long promised by the ELO process has primarily been limited by the inability to fully recover the original wafer surface quality after each growth leading to a limited number of times the substrate can be recycled due to accumulation of defects, and due to wafer thinning incurred by chemo-mechanical polishing. Considerable efforts in developing photovoltaics have therefore focused on achieving low cost while increasing their power conversion efficiency (PCE). However, high PCE alone does not necessarily translate into low cost solar energy production when expensive active materials and fabrication processes are used in their manufacture.

As an alternative to simply improving the PCE, solar concentrators have been demonstrated as a means for reducing the use of costly active solar cell materials. However, most concentrators suffer from a significant roll-off in efficiency at large light incident angles and can also result in high cell operating temperatures, thereby necessitating expensive active solar tracking and solar cell cooling systems. In view of the foregoing, there is a need to further reduce the production cost by integrating a thin film GaAs solar cell with a low-cost, plastic mini-compound, parabolic concentrator (CPC) by combining the non-destructive ELO (ND-ELO), cold-weld bonding and a vacuum-assisted thermoforming processes.

WO 2013/006803 discloses a thin-film solar cell that is integrated into a solar collector, wherein the solar collector is molded into a shape chosen from a compound parabolic collector or a Winston collector.

The inventors have discovered a method of making thin-film solar cells integrated with low-cost, thermoformed, lightweight and wide acceptance angle mini-CPCs, the method being defined in claim 1. The fabrication combines rapid ND-ELO thin film cells that can be cold-welded to a foil substrate, and subsequently can be attached to the CPCs in an adhesive-free transfer printing process. The combination of low-temperature operation of the thin-film solar cells along with the highly truncated low-profile plastic CPCs provides 2.8 times enhanced energy harvesting throughout the year without the need for active solar tracking, while eliminating losses incurred at high operating temperatures characteristically encountered in concentration systems.

Thus, there is disclosed a method for integrating a thin-film solar cell with non-tracking mini-concentrators according to claim 1. In an embodiment, the method comprises providing a growth substrate; depositing at least one protection layer on the growth substrate; depositing at least one sacrificial layer on the at least one protection layer; depositing a photoactive cell on the sacrificial layer, wherein the photoactive cell is inverted; and forming a patterned metal layer comprising an array of mesas on the photoactive cells by a photolithography method. After forming the array of mesas, the method comprises bonding the patterned metal layer to a metallized surface of a plastic sheet, and etching the sacrificial layer with one or more etch steps that remove the photoactive cell from the growth substrate to form thin film solar cells. The method then comprises fabricating compound parabolic concentrators from a plastic material using at least one thermoforming process, and transferring the thin film solar cells onto the thermoformed compound parabolic concentrators by an adhesive-free bonding step to form an integrated thin-film solar cell and compound parabolic concentrator.

The present disclosure describes a photovoltaic device comprising a thin-film solar integrated with non-tracking mini-compound parabolic concentrators made from the disclosed method. For example, the photovoltaic device comprises a thin-film solar cell bonded to a plastic compound parabolic concentrator, wherein the plastic compound parabolic concentrator comprise two parabolas tilted at an angle equal to the acceptance angle of the compound parabolic concentrator. In this embodiment, the solar cell is able to collect light at angles broader than the acceptance angle of the compound parabolic concentrator.

Aside from the subject matter discussed above, the present disclosure includes a number of other exemplary features such as those explained hereinafter. It is to be understood that both the foregoing description and the following description are exemplary only.

### BRIEF DESCRIPTION OF THE DRAWINGS

The accompanying figures are incorporated in, and constitute a part of this specification.
**Figs. 1(a)** to **1(c)** are schematic illustrations of fabrication flow for pre-mesa patterning, cold welding and ELO process.
**Fig. 2** is a schematic illustration of a fabrication flow for the plastic mini- CPC via vacuum-assisted thermoforming technique.
**Figs. 3(a)** to **3(c)** are schematic illustrations showing various aspects of the self -aligned transfer printing process that can be used in the present disclosure.
**Fig. 4** is a graph showing current-voltage characteristics of ND-ELO processed GaAs thin film solar cell with and without a CPC measured under simulated one sun illumination.
**Figs. 5(a)** to **5(e)** describe two dimensional mini- CPC designs according to the present disclosure.
**Fig. 6** is a schematic illustration of two different cylindrical CPC alignments along a solar path showing 4(a) north-south axis alignment and 4(b) east-west axis alignment.
**Figs. 7(a)** to **7(d)** show performance of a thin-film GaAs solar cells under the concentrated light.
**Fig. 8** shows operating temperature of the thin-film and the substrate GaAs solar cells. Time dependent temperature measured by by IR imaging under 1 sun illumination (100mW/cm²).
**Figs. 9(a)** and **9(b)** show a comparison of the power generation from tilted solar cells with and without the CPC and tracking for summer (9a) and winter (9b), at Phoenix, Arizona.
**Figs. 10(a)** to **10(d)** show performance characteristics of solar cells made according to the present disclosure.
**Figs. 11(a)** to **11(d)** show characterization of hourly and annual energy harvesting using CPCs according to the present disclosure.
**Figs. 12(a)** to **12(c)** show optimum alignment of CPCs for maximum annual energy harvesting, including: **Fig. 12(a)** showing polar plots showing coverage of CPC at its optimum seasonal positions; **Fig. 12(b)** showing contour plot of daily and hourly concentration factors in Phoenix, AZ using a 6° tilted CPC; and **Fig. 12(c)** showing the ratio of the daily concentrated energy harvesting factor for the thin-film GaAs solar cells with the 6° tilted CPC compared to a cell without concentration.

### DETAILED DESCRIPTION

### Definitions

As used herein, the term "acceptance angle" is the maximum angle at which incoming sunlight can be captured by a solar concentrator, such as a compound parabolic concentrator.

As used herein, the term "lll-V material," may be used to refer to compound crystals containing elements from group IIIA and group VA of the periodic table. More specifically, the term "lll-V material" may be used herein to refer to compounds which are combinations of the group of Gallium (Ga), Indium (In) and Aluminum (Al), and the group of Arsenic (As), Phosphorous (P), Nitrogen (N), and Antimony (Sb).

It should be noted that the lll-V compounds herein are named in an abbreviated format. A two component material is considered to be in approximately a 1:1 molar ratio of group lll:V compounds. In a three or more component system (e.g. InGaAIAsP), the sum of the group III species (i.e. In, Ga, and Al) is approximately 1 and the sum of the group V components (i.e. As, and P) is approximately 1, and thus the ratio of group III to group V is approximately unity.

Names of lll-V compounds are assumed to be in the stoichiometric ratio needed to achieve lattice matching or lattice mismatching (strain), as inferred from the surrounding text. Additionally, names can be transposed to some degree. For example, AIGaAs and GaAIAs are the same material.

As used and depicted herein, a "layer" refers to a member or component of a device whose primary dimension is X-Y, *i.e.,* along its length and width. It should be understood that the term layer is not necessarily limited to single layers or sheets of materials. In addition, it should be understood that the surfaces of certain layers, including the interface(s) of such layers with other material(s) or layers(s), may be imperfect, wherein said surfaces represent an interpenetrating, entangled or convoluted network with other material(s) or layer(s). Similarly, it should also be understood that a layer may be discontinuous, such that the continuity of said layer along the X-Y dimension may be disturbed or otherwise interrupted by other layer(s) or material(s).

When a first layer is described as disposed or deposited "over" or "above" a second layer, the first layer is positioned further away from the substrate than the second layer. The first layer may be disposed directly on the second layer, but unless it is specified that the first layer is disposed or deposited "on" or "in physical contact with" the second layer, there may be other layers between the first layer and the second layer. For example, an epilayer may be described as disposed "over" or "above" a sacrificial layer, even though there may be various layers in between. Similarly, a protection layer may be described as disposed "over" or "above" a growth substrate, even though there may be various layers in between. Similarly, when a first layer is described as disposed or deposited "between" a second layer and a third layer, there may be other layers between the first layer and the second layer, and/or the first layer and the third layer, unless it is specified that the first layer is disposed or deposited "on" or "in physical contact with" the second and/or third layers.

As used herein the term "semiconductor" denotes materials which can conduct electricity when charge carriers are induced by thermal or electromagnetic excitation. The term "photoconductive" generally relates to the process in which electromagnetic radiant energy is absorbed and thereby converted to excitation energy of electric charge carriers so that the carriers can conduct, *i.e.,* transport, electric charge in a material. The terms "photoconductor" and "photoconductive material" are used herein to refer to semiconductor materials which are chosen for their property of absorbing electromagnetic radiation to generate electric charge carriers.

As used herein, the terms "wafer" and "growth substrate" can be used interchangeably.

As used herein the term "etchant selectivity" refers to the rate at which a particular etchant removes a particular material when compared to the rate of etching of another material. Etchant selectivity of X and Y is quantified as the ratio between the etching rate of X to the etching rate of Y for a particular etchant. Accordingly, "highly selective," as used herein, refers to instances where one material is etched rapidly while the other is etched very slowly or not etched at all, such as greater than 10:1, or 100:1, or 1000:1, 10,000:1 or greater.

Compared to elemental semiconductors such as Si or Ge, compound semiconductors often have superior properties useful in high efficiency solar cells. However, wafers on which active device regions are grown are prohibitively costly, limiting their use for practical solar cells. As a result ELO, whereby lll-V semiconductor solar cells are removed from the substrate by selectively etching away an AlAs "sacrificial layer" between the wafer and the cell epi (also referred to as photoactive cell), are described herein to reduce costs by allowing for wafer reuse.

The non-destructive substrate reuse method without performance degradation described herein provides the potential for dramatic production cost reduction. In addition, the disclosed method extends the application of high performance group lll-V optoelectronic devices by moving from bulky, two dimensional substrate-based platforms to conformal, flexible and light weight thin-film devices. Moreover, direct integration of thin-film solar cells with low cost concentrators, such as plastic parabolic concentrators, can further reduce the cost for solar to electrical energy conversion.

As shown herein, the integration of thin-film GaAs solar cells produced by an accelerated ND-ELO fabrication process, and integrated with simple, thermoformed mini-concentrators can lead to dramatic reductions in the cost of the production of electricity via solar energy harvesting. This approach reduces cell materials and fabrication costs to a minimal level, such as about 3% of that of analogous substrate-based GaAs cells, and only 11% of ELO-processed GaAs solar cells, while the optical system maximizes the annual energy output without requiring daily active solar tracking systems by using highly-truncated two dimensional mini-compound parabolic concentrators (CPCs).

The low-profile concentrator described herein provides a thin and lightweight module with improved off-angle sunlight absorption compared to conventional concentrators both in direct, as well as diffuse sunlight with only minor losses. The disclosed approach eliminates the need for high concentration factor optics that require expensive and heavy solar tracking paraphernalia. Furthermore, the unique geometry of the disclosed thin-film GaAs solar cells that are mounted on a heat-sinking metal layer enable operation at or near room temperature without active cooling, even for concentration factors approaching 4×, representing a reduction of over 40 °C when compared to substrate-based GaAs solar cells.

### THIN-FILM INORGANIC SOLAR CELL FABRICATION

There is disclosed a non-destructive ELO (ND-ELO) process that eliminates wafer damage by employing surface protecting layers interposed between the wafer and the epitaxial structure, which consists of multilayer structure, including sequential protection, sacrificial and active device layers. The protection layers comprise protection and buffer layers, which are generally lattice matched layers having a thickness ranging from 5 to 200 nm, such as 10 to 150 nm, or even 20 to 100 nm. These layers are generally grown by gas source, such as gas source molecular beam epitaxy (GSMBE). Other suitable deposition techniques for preparing the growth structure include, but are not limited to, metallo-organic chemical vapor deposition (MOCVD), hydride vapor phase epitaxy (HVPE), solid source molecular beam epitaxy (SSMBE), and chemical beam epitaxy.

In one embodiment, the substrate may comprise GaAs, and the substrate protective layers and device structure protective layers may be lattice matched compounds, such as AlAs, GaAs, AllnP, GalnP, AlGaAs, GaPSb, AlPSb and combinations thereof. In another embodiment, the substrate may comprise GaAs and the substrate protective layers and device structure protective layers may be strained layers, such as InP, InGaAs, InAIAs, AllnP, GalnP, InAs, InSb, GaP, AIP, GaSb, AlSb and combinations thereof, including combinations with lattice matched compounds.

Examples of suitable lll-V materials for the one or more protective layers include, but are not limited to, AllnP, GalnP, AIGaAs, GaPSb, AlPSb, InP, InGaAs, InAs, InSb, GaP, AIP, GaSb, AlSb, InAIAs, GaAsSb, AlAsSb, and GaAs. In some embodiments, when the growth substrate is GaAs, the one or more protective layers are chosen from lattice matched AllnP, GalnP, AIGaAs, GaPSb, AIPSb, and strained InP, InGaAs, AllnP, GalnP, InAs, InSb, GaP, AlP, GaSb, AlSb. In some embodiments, when the growth substrate is InP, the one or more protective layers are chosen from lattice matched InGaAs, InAIAs, GaAsSb, AlAsSb, and strained InGaAs, InAIAs, GaAsSb, InAs, GaSb, AlSb, GaAs, GaP and AIP. U.S. Patent No. 8,378,385 and U.S. Patent Publication No. 2013/0043214 disclose protective layer schemes.

The protection layer may further comprise one or more protective layers, as described. In some embodiments, the protection layer further comprises one protective layer. In other embodiments, the protection layer further comprises two protective layers. In other embodiments, the protection layer further comprises three or more protective layers. The protective layer(s) may be positioned between the growth substrate and the sacrificial layer.

A sacrificial release layer is then grown onto the protection layers. One non-limiting example of such a layer is AlAs. When using this material as a sacrificial layer, arsenic oxide buildup can slow the AlAs etch during lift-off. Thus, by cladding the AI(Ga)As with a slowly etched lll-V material (e.g. InAlP, AIGaAs, InAIGaP) the arsenic oxide buildup can be reduced; thus, expediting the lift-off process. U.S. Patent Publication No. 2010/0047959 describes a method for selectively freeing an epitaxial layer from a single crystal substrate.

In one embodiment, the active thin-film device region can be lifted-off by selectively etching a sacrificial layer using a known acid. The sacrificial layer of the growth structure acts as a release layer during ELO for releasing the epilayer from the growth substrate. The sacrificial layer may be chosen to have a high etch selectivity relative to the epilayer and/or the growth substrate so as to minimize or eliminate the potential to damage the epilayer and/or growth substrate during ELO. It is also possible to use protective layers between the sacrificial layer and the epilayer to protect the epilayer during ELO. In some embodiments, the sacrificial layer comprises a lll-V material. In some embodiments, the lll-V material is chosen from AlAs, AIGaAs, AllnP, and AlGalnP. In certain embodiments, the sacrificial layer comprises AI(Ga)As. In some embodiments, the sacrificial layer has a thickness in a range from about 2 nm to about 200 nm, such as from about 4 nm to about 100 nm, from about 4 nm to about 80 nm, or from about 4 nm to about 25 nm.

The step of releasing the sacrificial layer by etching may be combined with other techniques, for example, spalling. WO 2015/073089 discloses releasing an epilayer via combination of etching and spalling.

Next, the epilayer (or active device region) is grown, typically in inverted order such that after bonding to the secondary plastic substrate, devices can be fabricated in their conventional orientation, thereby eliminating a second transfer step often employed in ELO device processing. The epilayer of the growth structure refers any number of layers desired to be "lifted off' of the growth substrate. The epilayer, for example, may comprise any number of active semiconductor layers for fabricating an electronic or optoelectronic device. Thus, the epilayer is sometimes referred to as a "active device region." The epilayer may comprise layers for fabricating devices including, but not limited to, photovoltaics, photodiodes, light-emitting diodes, and field effect transistors, such as metal-semiconductor field-effect-transistors and high-electron-mobility transistors. In some embodiments, the epilayer comprises at least one lll-V material.

In one embodiment, after the substrate is bonded to the plastic substrate, the active device region may be lifted-off from the parent wafer by immersion etching, such as with an acid.

In one embodiment, the photovoltaic cell comprises an active photovoltaic region comprising a flexible crystalline semiconducting cell. Non-limiting examples of the single junction semiconducting cell includes InGaP, GaAs, InGaAs, InP, or InAIP. The flexible crystalline semiconducting cell typically has a thickness ranging from 2 to 10 µm, such as from 3-6 µm.

In another embodiment, the photovoltaic cell comprising an active photovoltaic region comprising multi-junctions cells, such as tandem photovoltaic (with two sub-cells), triple junction cells (three sub-cells), or even quad junction cells (four sub-cells).

After the photovoltaic cell is formed, it is coated with a conductive metal coating on one surface. Non-limiting examples of the metal coating includes at least one metal chosen from Au, Ag, Pt, Pd, Ni, and Cu, with a particular emphasis on Au. In one embodiment, the Au layer on the support substrate has a thickness ranging from 100-500 nm, such as from 200-400 nm.

Once the photovoltaic cell is removed from the growth substrate by the non-destruction ELO process described above, it is mounted on the support structure by various bonding process. For example, the active photovoltaic region, whether single junction or multi-junction cells, may be applied to the host substrate by a direct-attachment bonding process. This process comprises adding metal layers to adjoining surfaces of the active region and the flexible host substrate and using cold-welding to bond them. Cold-weld bonding processes typically include pressing two surfaces together at room temperature to achieve a uniformly bonded interface.

Alternative direct-attachment bonding processes may include thermo-compression bonding, which typically involves the application of a lower pressure but at a high temperature (i.e., higher than the metal re-crystallization temperature). This process is typically not used when the flexible substrate has a glass transition and/or a melting temperature below the re-crystallization temperature of metal layers used in direct-attachment bonding processes.

Another direct-attachment technique for bonding metal layers associated with an ELO process that may be used is a thermally-assisted cold-weld bonding process using a lower pressure than typical cold-welding processes and a lower temperature than typical thermo-compression bonding processes. Particularly, thermally-assisted cold-welding may reduce the likelihood of damaging semiconductor wafers, thereby increasing the reuse rate of the wafers for growing additional active regions.

Non-limiting examples of the direct-attachment bonding processes that can be used herein include cold-welding, thermally assisted cold-welding, or thermo-compression bonding. U.S. Patent Application Publication No. US 2013/0037095 describes cold-welding.

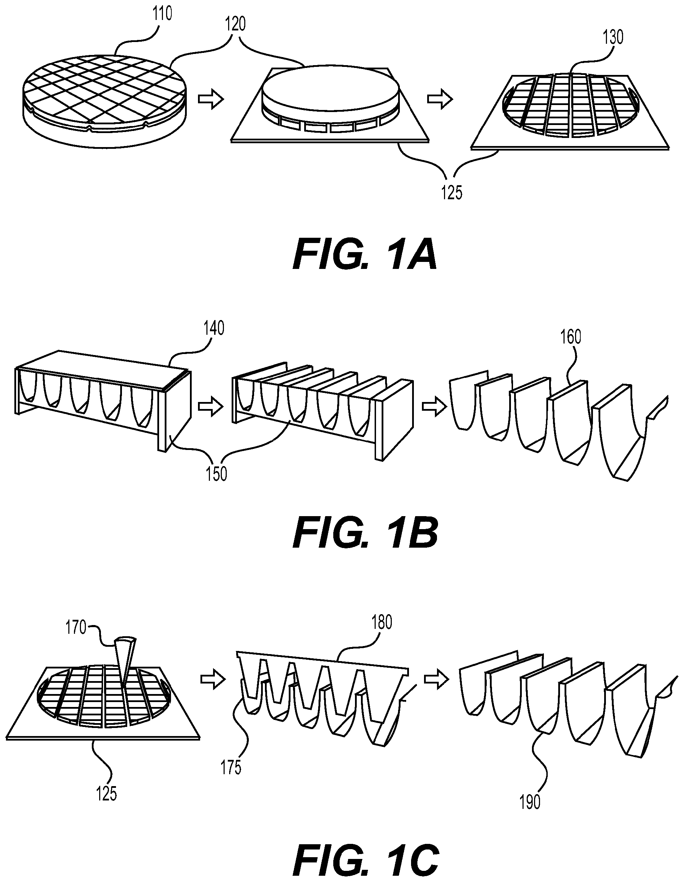

The accelerated ND-ELO process employs laser dicing. For example, **Fig. 1** shows the fabrication sequence of the thin-film GaAs solar cells via the combination of rapid ND-ELO and cold-weld bonding, according to one aspect of the present disclosure. Known ND-ELO methods typically employ epitaxial protection layers grown between the sacrificial layer and the wafer that completely preserves the original wafer surface quality, even at the atomic scale, during the ELO process.

Selective removal of protection layers using wet chemical etching eliminates the need for chemo-mechanical polishing used in conventional ELO. Therefore, ND-ELO allows for the nearly indefinite reuse of the GaAs substrates, converting their cost from a materials expense into a capital investment. However, the process is time-consuming. To accelerate conventional ELO that takes several hours to separate the active epitaxy from even a small wafer, a thick metal layer, such as a layer greater than 100 nm, such as 200 nm to 500 nm, such as a 350 nm thick Au layer, may be deposited onto the epitaxial layer surface. The metal layer is photo-lithographically patterned to form a mask for the formation of an array of mesas separated by defined trenches, such as 100 µm to 500 µm wide trenches by wet chemical etching that terminates at the active solar cell epitaxy/AlAs sacrificial layer interface.

**Fig. 1** illustrates the fabrication steps for integration of CPCs with thin-film GaAs solar cells. Fig. 1(a) shows (from left to right): Mesas (110) that have been pre-patterned prior to non-destructive epitaxial lift-off (ND-ELO) by selective etching that stops at the AlAs sacrificial layer (120). The sample is then bonded onto the Au coated Kapton^{®} sheet (125) via cold-welding. The third step shows the sample (130) following ND-ELO.

**Fig. 1(b)** illustrates the thermoforming process used in fabricating the mini-CPCs according to one aspect of the present disclosure. Here it shows that the process employs three molds: a metal mold to shape the thermoformed CPC, another for making an elastomeric stamp to transfer the solar cells onto the substrate, and a third to assist in solar cell alignment. With further reference to **Fig. 1(b)****,** a PETG sheet (140) is shown to be fixed on top of the metal mold (150). Then the PETG is thermoformed into its final shape by applying heat and vacuum. Finally, the mini-CPCs are detached from the mold (160).

**Fig. 1(c)** shows a solar cell-Kapton® sheet assembly that is separated into individual bars using laser dicing (170). For example, in one embodiment, a CO₂ laser engraving and cutting system (X-660 superspeed-600, Universal Laser Systems, Inc.) can be used to dice the non-destructive epitaxial lift-off (ND-ELO) processed thin-film GaAs solar cells bonded to a Kapton® sheet (125). Then, each bar is transfer printed onto the mini-CPCs (175) using a PDMS stamp (180) via low-pressure cold-welding. The last schematic shows the integrated thin film solar cells and mini-CPC after reflective metal coating is deposited onto the CPC array surface (190).

With additional reference to **Fig. 1(c)****,** an embodiment is shown of a self-aligned transfer printing for thin-film GaAs solar cells onto plastic CPCs that can be used according to an embodiment. In this embodiment, an acrylonitrile butadiene styrene (ABS) mold for an polydimethylsiloxane (PDMS) stamp (180) can be used to integrate and align the thin-film GaAs solar cells with plastic mini-CPCs is fabricated using a 3D printer (Dimension Elite, Stratasys).

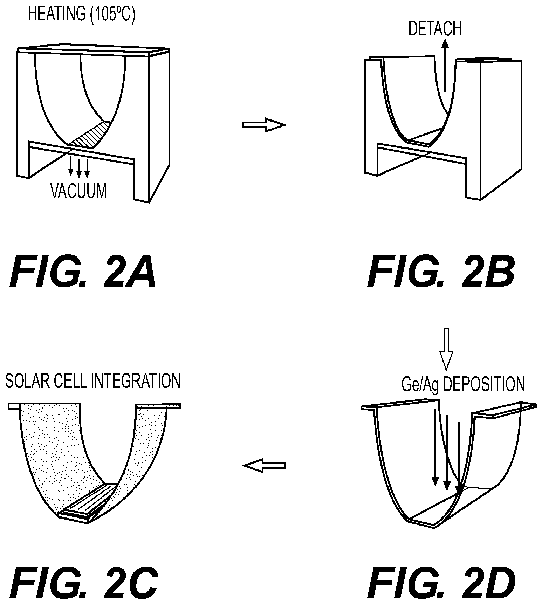

**Fig. 2** provides additional information of the fabrication process used to fabricate the parabolic concentrator array shown and described in **Fig. 1(b)****.** Here, a deformable medium (e.g. polymer) can be molded to cylindrical paraboloids mini-concentrator using a vacuum mold and oven. The entire molded array of this embodiment can be extremely lightweight (as it can be made entirely comprised of plastic and thin metal films) and have some limited flexibility when complete. With the reflective surface facing up, the concentrator is designed such that the line of focal point is located right at the center of the concentrator opening plane, which allows the full collection of light incident into the cylindrical paraboloids mini-concentrator.

With reference to **Fig. 2(a)****,** the thermoforming process may comprise heating a PETG sheet to 105 °C while a vacuum is used to pull the PETG to the shape of the mold. After the CPC is thermoformed into its final shape by applying heat and vacuum, it can be detached from the mold, as shown in **Fig. 2(b)****.** Next, the solar cells are integrated into the detached CPC by transfer printing onto the mini-CPCs. As described in **Fig. 1(c)****,** solar cell integration may be accomplished using a PDMS stamp (180) via low-pressure cold-welding. **Fig. 2(d)** shows the integrated thin film solar cells and mini-CPC after reflective metal coating is deposited onto the CPC array surface (190).

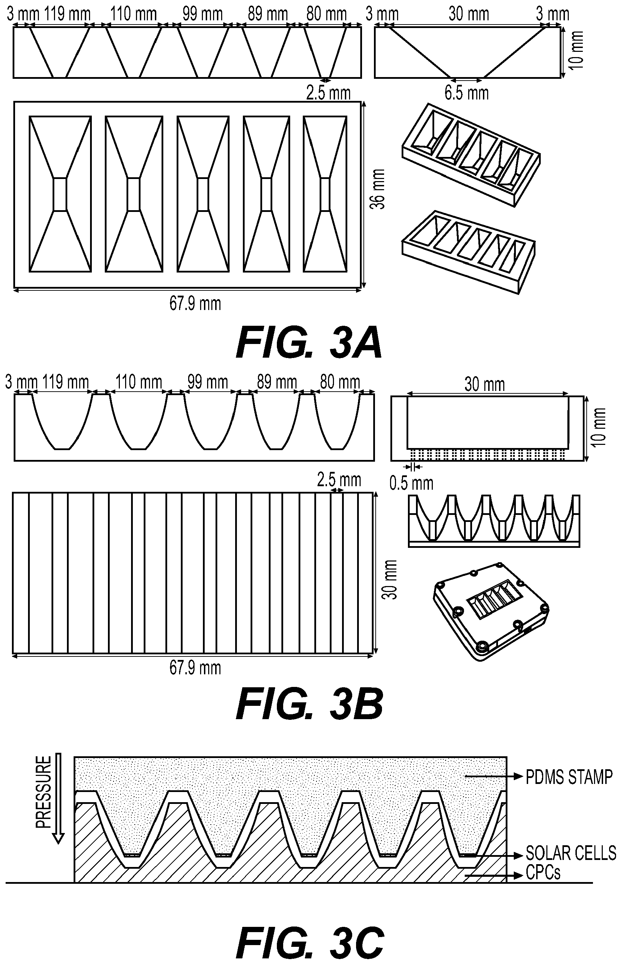

**Fig. 3(a)** shows the detailed dimensions and photographs of the mold for the PDMS stamp, which is designed to exactly fit into the CPC opening shown in **Fig. 3(b)****.** An additional 3D printed mold may be used to align the solar cell strips for pick-up by the PDMS stamp. The pyramid shape of the PDMS stamp prevents direct contact between the stamp and the side walls of the CPC so that pressure for bonding the solar cells is only applied onto the CPC base. **Fig. 3(c)** is a schematic of the fit between the stamps and CPCs.

### Mini-compound parabolic concentrator (CPC) design

The CPCs described herein may be fabricated from a flexible material comprises, including a plastic material, such as a polyimide, or metal foil. The support structure typically has a thickness ranging from 25 to 100 µm , such as 40 to 60 µm. When the flexible material comprises a plastic material, it typically has a conductive metal coating on one surface. Non-limiting examples of the metal coating includes at least one metal chosen from Au, Ag, Pt, Pd, Ni, and Cu, with a particular emphasis on Au. In one embodiment, the Au layer on the support substrate has a thickness ranging from 100-500 nm, such as from 200-400 nm.

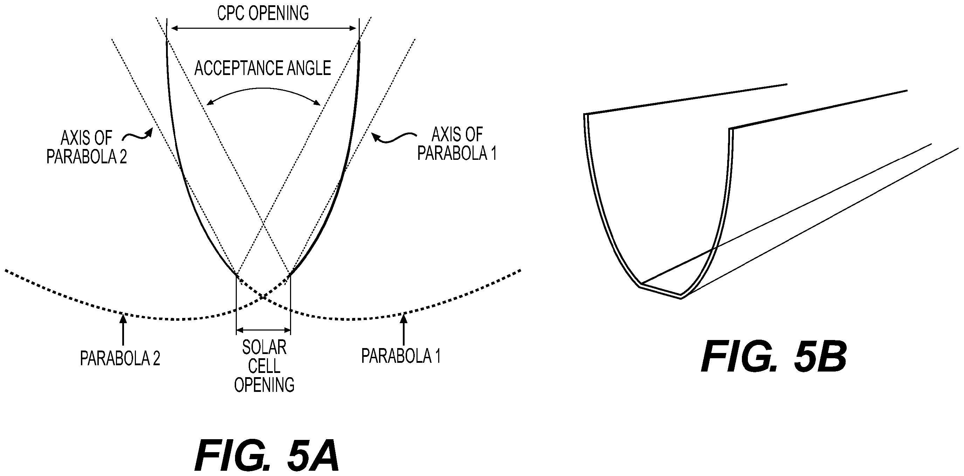

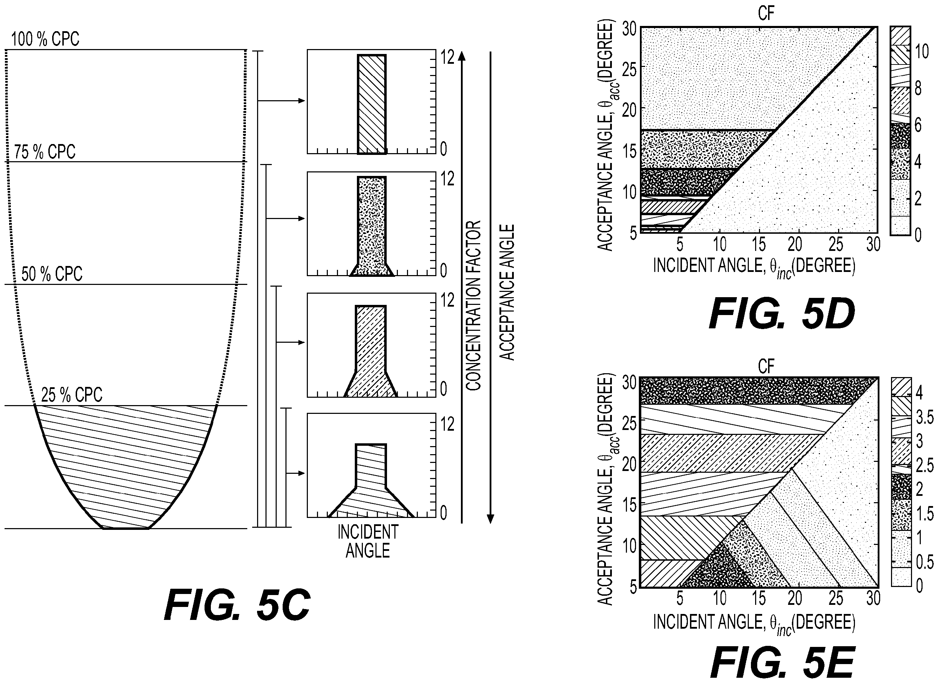

**Figs. 5(a)** and **5(b)** show schematics for a CPC comprised of two parabolas with tilted axes at an angle equal to its acceptance angle. The plastic mini-CPCs are 2D, half cylinders to eliminate the need for solar tracking along its longitudinal axis. **Figs. 5(c)** shows the effect of CPC truncation on the acceptance angle and concentration factor, CF. A non-truncated CPC shows the highest CF with no light collection outside of the acceptance angle. Although the CF is reduced with increased truncation, it is nevertheless able to collect light at much broader angles than the acceptance angle.

Ray tracing using Matlab software (MathWorks) was used to determine the CF. The geometry of the CPC efined in Cartesian coordinates, and its four vertices were calculated using base width (defined by the dimensions of the GaAs solar cell), height, and acceptance angle. Note that the focal points of the two parabolas comprising the CPC form the base edges. Practical CPC heights (-8% of the untruncated CPC), were chosen where truncation alters the acceptance of input rays incident on CPC, and hence the CF. It was assumed that the input rays were parallel.

Now, CF is the ratio of photons incident on solar cell with CPC, to that without it. Due to the symmetry of the CPC about its central axis, only positive solar incident angles were considered, i.e., 0 *< θₛᵤₙ < θₘₐₓ, where θₛᵤₙ* is the angle of the rays with respect to the central axis of CPC, and *θₘₐₓ* is the angle at which all incident rays are shadowed and thus, *CF→* 0. Greater than 10,000 spatially distributed rays for each angle were used. When a ray is reflected by the CPC, its intensity is reduced by the reflectance of Ag, which was measured on PETG using a variable-angle spectroscopic ellipsometer (VASE, J.A. Woollam) and a UV/Vis/NIR Spectrophotometer (LAMBDA 1050, Perkin Elmer). The range of wavelengths and angles was 300 nm to 900 nm with 3 nm steps, and from 15° to 85° with 5° steps. The values between those measured are interpolated. Then, the wavelength and incident angle dependent reflectance is weighted by the AM1.5G solar spectrum. Finally, *CF vs. θₛᵤₙ* and acceptance angle is calculated.

**Figs. 5(d)** and **(e)** show contour plots of CF vs. incident angle calculated for various CPC shapes. **Figs. 5(d)** shows the case of a non-truncated CPC where CF increases as the angle between each parabola axis (i.e. the acceptance angle) decreases. **Figs. 5(e)** shows the case of CPCs with a fixed aspect ratio of 4 (solar cell width/CPC height/solar cell width) such that the truncation ratio depends on acceptance angle. The truncation ratios of CPCs with narrow acceptance angles are higher than for wide acceptance angles.

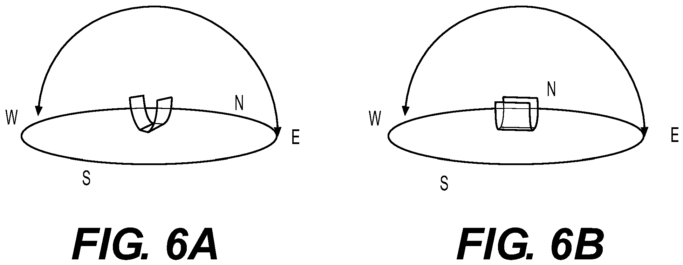

In one embodiment, the CPC comprises a cylindrical symmetry. In this embodiment, the acceptance angle of the concentrator is limited to only single axis. **Fig. 6** shows two different alignment geometries that can be achieved by the mini-CPC cylinder. **Fig. 6(a)** and **6(b)** exhibit the CPC longitudinal axis aligned with the north-south axis and the east-west axis, respectively. In the case of the north-south alignment without tracking, the CPC only collects sunlight during the time of day where the sun lies within the 40° acceptance angle of the CPC; however, the east-west axis alignment provides a wide coverage of sunlight during the day, even without tracking, by tilting toward the solar declination path. The position of the CPC needs to be adjusted only 4 times per year for optimum energy harvesting since the acceptance angle of the CPC is sufficiently wide to cover the seasonal changes in the solar path.

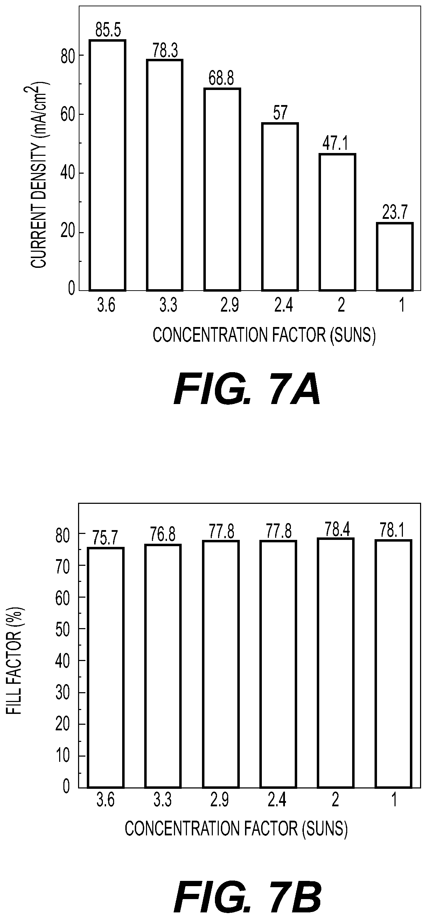

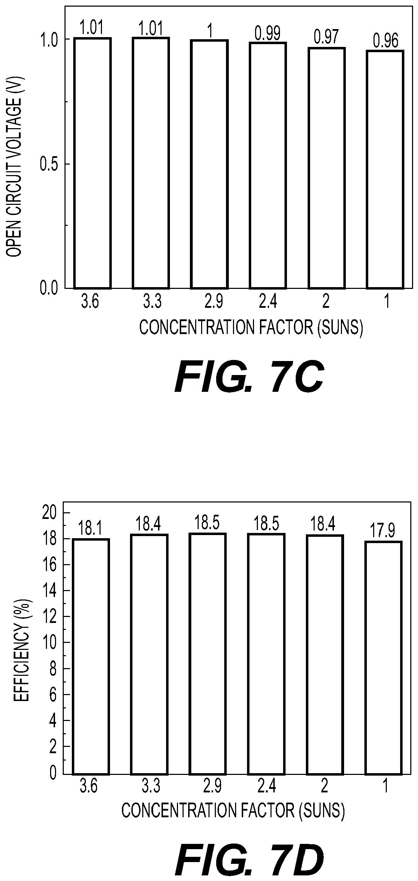

Characteristics of thin-film GaAs solar cells made according to the present disclosure and measured under the concentrated light are described as follows. **Figs. 7(a)** to **7(d)** show performance of a thin-film GaAs solar cells under the concentrated light. **Fig. 7(a)** shows short circuit current. **Fig. 7(b)** shows fill factor. **Fig. 7(c)** shows open circuit voltage, and **Fig. 7(d)** shows power conversion efficiency of the thin-film GaAs solar cells under the various concentrated light conditions measured by their integration with the mini-CPCs.

With reference to Figs. 7(a) to 7(d), the solar cells are integrated with the mini-CPCs as previously described, and are measured using a solar simulator calibrated to AM 1.5G illumination at 1 sun (100 mW/cm2) using a Si photodiode. Short circuit current (Jsc), Open circuit voltage (Voc), fill factor, and power conversion efficiency (PCE) are extracted from the l-V characteristics. The measurement shows the power conversion efficiency of the cell integrated with a 6° tilted CPC with CF= 3.3 is slightly improved (-0.5%) compared to a non-concentrated device with one due to the increased open circuit voltage, Voc, at higher intensities.

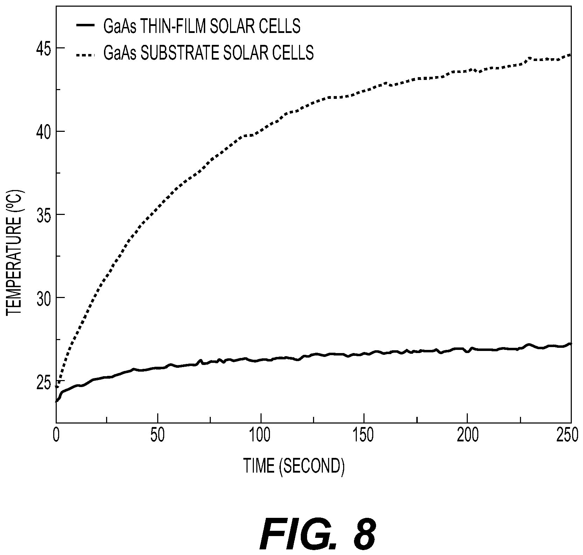

A comparison of solar cell operation temperature under 1 sun illumination is provided in **Fig. 8****,** which shows the operating temperatures of thin-film and substrate-based GaAs solar cells under simulated AM 1.5G, 1 sun intensity (100mW/cm²) illumination. After 250 s, the substrate-based GaAs solar cells operate around 45 °C as predicted, whereas the thin-film cells operate at a much lower 28 °C.

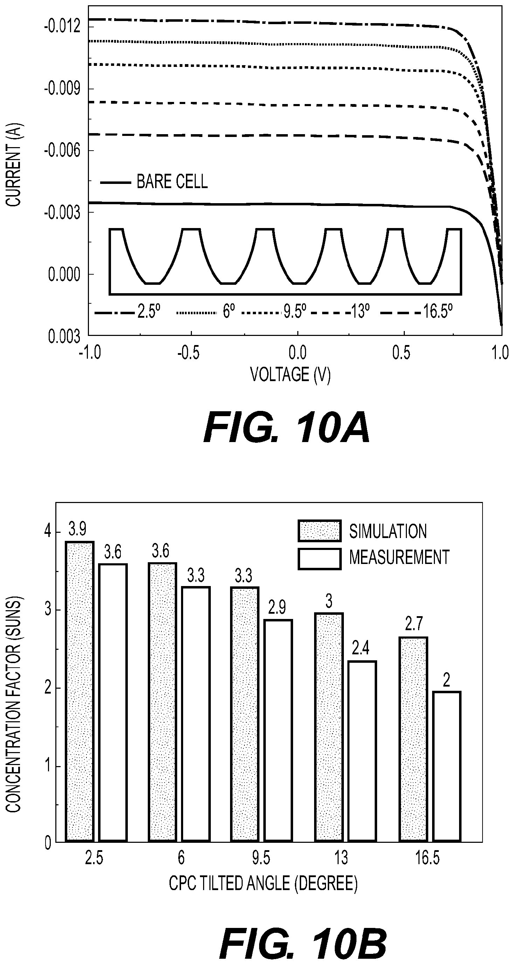

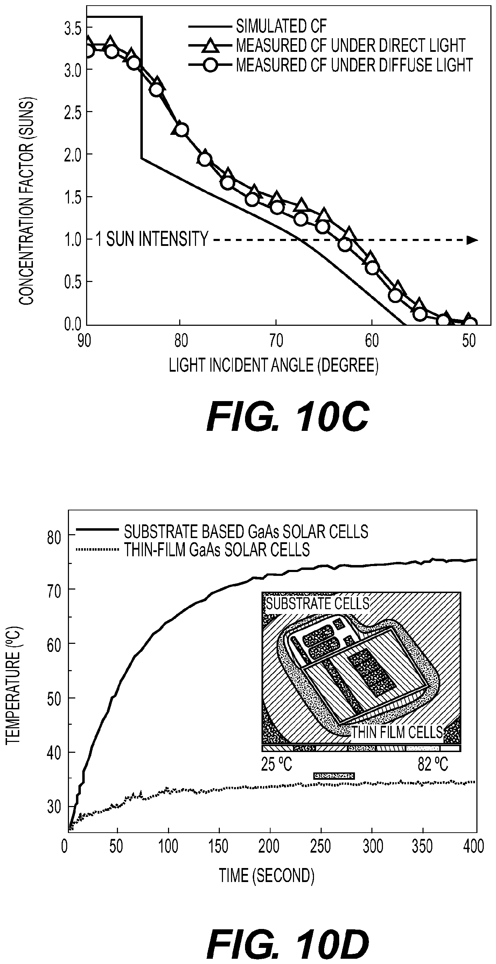

**Fig. 10(a)** shows the current-voltage (*I-V*) characteristics of the thin-film GaAs solar cells measured under simulated AM 1.5G illumination at 1 sun (100 mW/cm²) intensity; **Fig. 10(b)** shows the dependence of the concentration factor on the tilt angles of the axes of the parabolas as inferred from the l-V characteristics along with the calculated values; **Fig. 10(c)** shows both the measured and calculated values of the concentration factor as functions of the solar incidence angle for the 92% height-truncated, 6° tilted CPC under both direct and diffuse illumination; **Fig. 10(d)** shows the thermal performance of both substrate-based and thin film GaAs solar cells under 3.3 suns concentration.

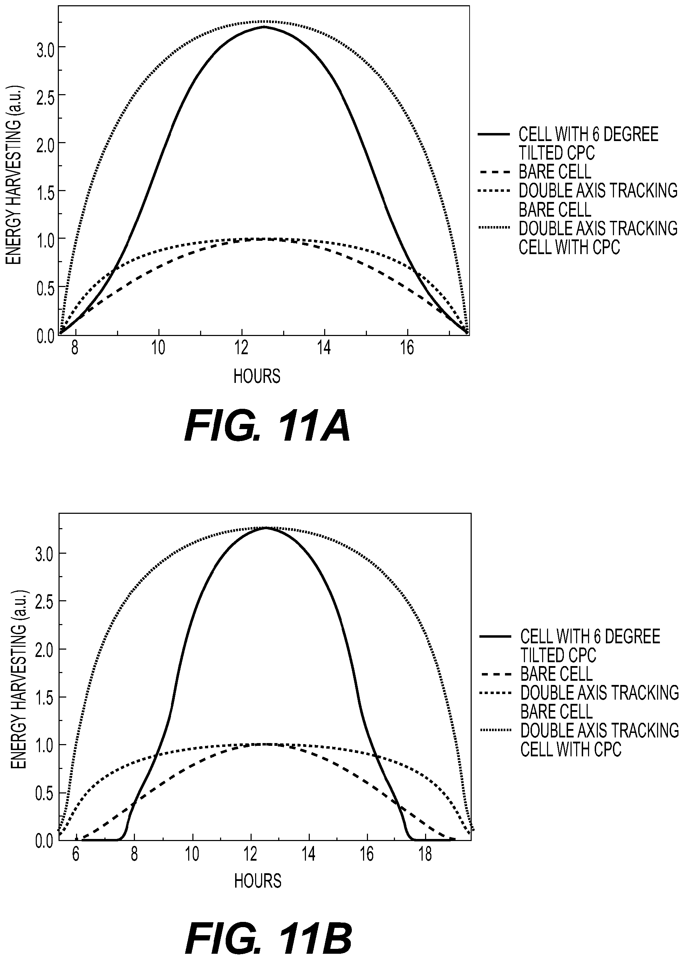

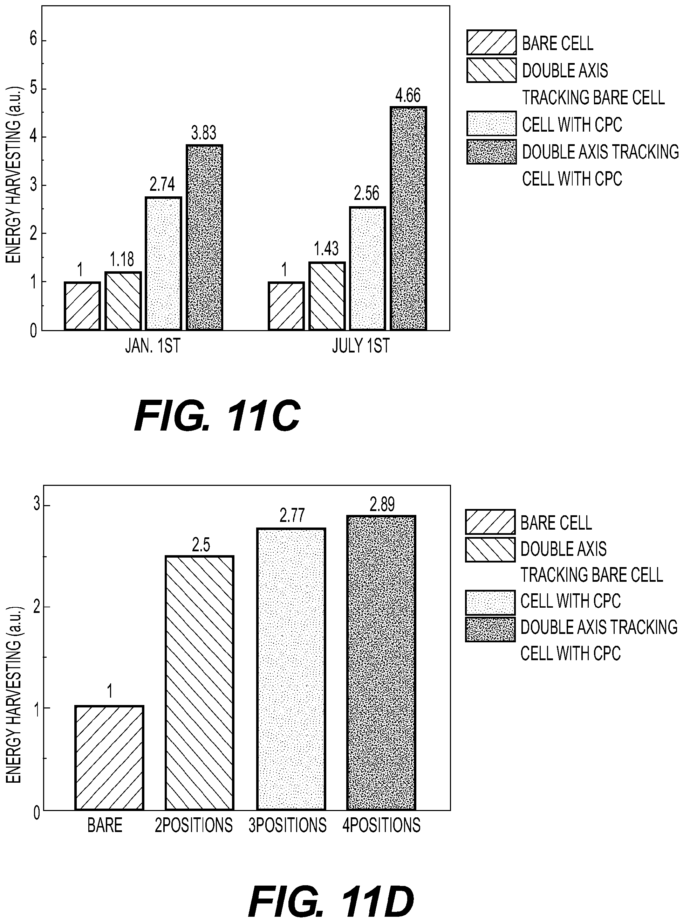

**Figs. 11(a)** and **11(b)** show the energy harvesting on two specific dates during winter and summer, respectively, using a 6° tilted CPC. The wide acceptance angle enables the CPC to cover most of the useful daylight with low air mass. From the integration of hourly energy harvesting curves for thin-film GaAs solar cells with and without a CPC, we confirm that the ND-ELO processed solar cells integrated with a 6° tilted CPC shows 2.8 and 2.7 times higher energy harvesting compared with non-concentrated cells on January 1^{st} and July 1^{st}, respectively **(****Figs. 11(c) and Fig. 11(d)****)** compares the non-concentrated, and the 2, 3 and 4 tilt positions per year.

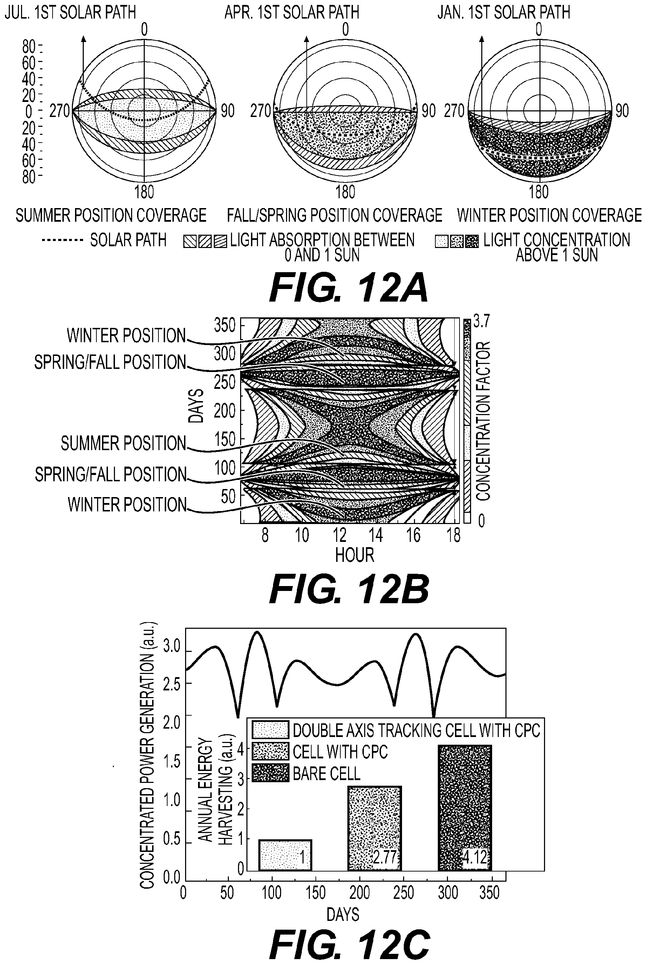

One benefit associated with the CPC/thin-film GaAs solar cell assemblies described herein is their enhanced annual energy harvesting characteristics. As described, the mini-CPC according to the present disclosure is cylindrically symmetric, suggesting that enhanced energy harvesting when aligned along an east-west axis. This alignment will provide the widest coverage of sunlight throughout the day simply by tilting its axis towards the zenith of solar declination path, with only occasional seasonal adjustments in tilt. In one embodiment, the seasonal alignments in Phoenix, AZ (33.4N, 112.1 W) are provided in **Fig. 12(a)****.** This shows the solar path at specific dates (January 1, April 1, and July 1) and the coverage of the 6° tilted CPC at seasonally adjusted tilt angles, such as adjusted to zenith angles of 11° / 31° / 53.5° only at the summer solstice, spring/fall equinoxes, and the winter solstice, respectively.

**Fig. 12(b)** shows the daily and hourly trends of concentrated power generation using the 6°-tilted CPC. The wide CPC acceptance angle allows for energy harvesting during the most useful hours of daylight straddling midday. **Fig.** 12(c) shows the result of concentrated energy harvesting throughout the year using a thin-film GaAs solar cell with the 6° tilted CPC compared to conventional, non-concentrated cells. Both cases are calculated based on three seasonal positional adjustments each year. The inset of **Fig. 12(c)** compares the annual energy generation of concentrated and non-concentrated thin-film GaAs solar cells. The total annual energy yield was found to be 2.8× higher for the concentrated cells.

The system, devices and methods described herein will be further described by the following non-limiting examples, which are intended to be purely exemplary.

### EXAMPLES

The following example demonstrates a method to integrate a thin film GaAs solar cell with a low-cost plastic mini-compound parabolic concentrator (CPC) by combining the non-destructive ELO (ND-ELO), cold-weld bonding and a vacuum-assisted thermoforming processes.

### Example 1

### Epitaxial growth

Solar cell epitaxial layer structures were grown by gas-source molecular beam epitaxy (GSMBE) on Zn-doped (100) p-GaAs substrates. The growth started with a GaAs buffer layer (0.2 µm thick) followed by InGaP/GaAs (100 nm/100nm) protection layers, and the AlAs (20 nm) sacrificial layer.

Next, an inverted active device region was grown as follows: 5 × 10¹⁸ cm-³ Be-doped GaAs (0.15 µm) contact layer, 2 × 10¹⁸ cm⁻³ Be-doped Al_{0.20}In_{0.49}Ga_{0.31}P (0.025 µm) window, 1 × 10¹⁸ cm-³ Be-doped p-GaAs (0.15 µm) emitter layer, 2 × 10¹⁷ cm-³ Si-doped n-GaAs (3.0 µm) base layer, 6 × 10¹⁷ cm-³ Si-doped ln_{0.49}Ga_{0.51}P (0.05 µm) back surface field (BSF) layer, and 5 × 10¹⁸ cm⁻³ Si-doped n-GaAs (0.1 µm) contact layer. The GaAs/AIAs layers were grown at 600 °C and Al_{0.20}In_{0.49}Ga_{0.31}P/ ln_{0.49}Ga_{0.51}P layers were grown at 480 °C.

### Pre-mesa patterning, cold weld bonding and epitaxial lift-off

Figure 1 (a) shows the schematic illustration of fabrication flow for pre-mesa patterning, cold welding and ELO process. 2.5 mm × 6.5 mm Cr/Au (4 nm/350 nm) mesas were patterned by photolithography using a LOR 3A and S-1827 (Microchem) bi-layer photoresist used as a mask for mesa etching using H₃PO₄:H₂O₂: deionized H₂O (3:1:25) and HCI: H₃P0₄ (3:1) for GaAs and InGaP, respectively. The patterned Au on the epitaxial GaAs wafer was bonded to the Aucoated 25 µm thick Kapton® sheet using an EVG 520 wafer bonder at ∼10⁻⁵ torr. Then, 4 MPa with a 80 N/sec ramp rate was applied to the 2 inch-diameter substrate to establish a bond between the Au films. The temperature was increased to 230°C at 25°C/min and held at temperature for 8 min. The substrate was then rapidly cooled. To apply uniform pressure, a soft graphite sheet was inserted between the sample and the press head. Once the GaAs substrate fully adhered to the Kapton® sheet, the thin active device region was removed from its parent substrate using ND-ELO. The sample was immersed in a 20% HF:H₂O maintained at 60°C while agitating the solution with a stir bar at 900 rpm. The total lift-off time was 30 min.

### Solar cell fabrication

Following lift-off, the thin-film active region and flexible plastic host was fixed to a rigid substrate using Kapton® tape. The front surface contact grid was photo-lithographically patterned using the LOR 3A and S-1827 (Microchem) bi-layer photoresist; then a Pd(5 nm)/Zn(20 nm)/ Pd(20 nm)/Au(700 nm) metal contact was deposited by e-beam evaporation. The widths of the grid and bus bar were 20 µm and 150 µm, respectively, and the spacing between the grid fingers was 300 µm. The total coverage of the solar cell active area by the metallization was 4%. After the metal layer was lifted-off, the highly-doped 100 nm p++ GaAs contact layer was selectively removed by plasma etching. The thin-film solar cells were annealed in air for 1 hr at 200 °C to form ohmic contacts. An anti-reflection coating bilayer comprised of 49 nm thick TiO₂ and 81 nm thick MgF₂ was deposited by e-beam evaporation. The solar cells on the plastic sheet were covered by a plastic film to protect them from debris generated during dicing along the etched trench using a CO₂ laser cutter (50 W Universal Laser Systems) with 2.5 W power, and 500 pulses per inch.

### Vacuum-assisted thermoforming of the CPCs

Fig. 2 shows the schematic illustration of vacuum-assisted thermoforming process for CPCs fabrication. The polyethylene terephthalate glycol-modified (PETG) sheet was fixed with Kapton^{®} tape across the top of a metal mold containing holes at its base. While vacuum was applied through the holes, the assembly was placed in an oven at 60°C. The PETG is drawn into the mold as the oven temperature was raised to 96°C for -15 min, forming the compound parabolic shape. The CPC was then cooled, after which CPC was detached from the metal mold.

### Characterization of concentrated GaAs photovoltaic

An Oriel solar simulator (model: 91191) with a Xe arc lamp and AM 1.5 Global filter was used for *I-V* measurements obtained with an Agilent 4155B parameter analyzer. The simulator intensity was calibrated using a National Renewable Energy Laboratory (NREL) certified Si reference cell with diameter of 5 mm. The light incident angle was adjusted using an optical fiber and rotation stage (Newport, 481-A). The concentration factor under diffuse illumination (N-BK7 ground glass diffusers, 220 grit polish, Thorlab) was measured with an identical set-up. The solar cell operating temperature was measured by a thermal imaging camera (A325, FLIR).

Properties related to the solar cell operating temperature is provided in **Fig. 10(c)****.** This shows both the measured and calculated values of the concentration factor as functions of the solar incidence angle for the 92% height-truncated, 6° tilted CPC under both direct and diffuse illumination. In addition, **Fig. 10(d)** shows the thermal performance of both substrate-based and thin film GaAs solar cells under 3.3 suns concentration.

### Example 2

The following example demonstrates a similar method to one described to integrate a thin film GaAs solar cell with a low-cost plastic mini-compound parabolic concentrator (CPC) by combining the non-destructive ELO (ND-ELO), cold-weld bonding and a vacuum-assisted thermoforming processes.

As in Example 1, **Fig. 2** shows the fabrication flow chart for the vacuum-assisted thermoformed cylindrical plastic mini CPC created using a negative vacuum mold. First, a PETG (Polyethylene terephthalate glycol-modified) plastic substrate with a low glass transition temperature (81 °C) was mounted on a negative compound-parabola shaped mold and placed in the furnace. At the base of the mold, uniformly-spaced small holes connected with the vacuum pump were used to pull the heated substrate (to 105 °C) downwards until it conformed to the mold shape.

The deformed substrate was then cooled to room temperature where it held its shape. Subsequently, the reflector was coated with a 5 nm thick Ge wetting layer and a 200 nm thick Ag reflecting layer on its inner surface using electron-beam and thermal evaporation, respectively. Prior to the deposition, the substrate was cleaned in a sequence of deionized water, tergitol, and isopropyl alcohol for 5 min each.

For the fabrication of thin film GaAs photovoltaic cells, the epitaxial layer structures were grown by gas-source molecular beam epitaxy (GSMBE) on Zn-doped (100) p-GaAs substrates. The growth started with a 0.2 µm-thick GaAs buffer layer followed by a 0.025 µm-thick AlAs sacrificial layer. Then, an inverted active device region (p-on-n GaAs solar cell active region) was grown as follows: 0.15 µm-thick, 5 x 10¹⁸ cm-³ Be-doped GaAs contact layer, 0.025 µm-thick, 2 x 10¹⁸ cm-³ Be-doped Al_{0.25}Ga_{0.26}ln_{0.49}P window layer, 0.15 µm-thick, 1 x 10¹⁸ cm⁻³ Be-doped p-GaAs emitter layer, 3.5 µm-thick, 2 x 10¹⁷ cm⁻³ Si-doped n-GaAs base layer, 0.05 µm-thick, 4 x 10¹⁷ cm⁻³ Si-doped In_{0.49}Ga_{0.51}P back surface field (BSF) layer, and a 0.1 µm-thick, 5 x 10¹⁸ cm⁻³ Si-doped n-GaAs contact layer.

After growth using GSMBE, a 0.005 µm-thick Ir layer was sputtered onto a 50 µm-thick Kapton^{®} sheet as an adhesion layer. Ir was also utilized as stressor layer to accelerate the ELO process. Then, 0.5 µm-thick Au contact layer was deposited onto both the Ir coated Kapton^{®} sheet and GaAs epitaxial layer by e-beam evaporation.

The substrate and plastic sheet were bonded by thermally-assisted cold-welding which consisted of applying a 4 kN force at 200 °C with an EAG 520 wafer bonding tool and then was subsequently submerged into a heated solution of 20% HF for epitaxial lift-off. The lifted-off thin film was fabricated into solar cells starting with the front contact grid patterning using photolithography and deposition of Pd (0.005 µm) / Zn(0.02 µm) / Pd(0.015 µm) / Au(0.7 µm) by e-beam evaporation. The device was then annealed for 30 min at 200 °C to form Ohmic contacts.

Mesas were defined using photolithography and wet etching, and the highly-doped GaAs ohmic contact layer was removed between the gridlines. Finally, a TiO₂ (0.052 µm)/MgF₂ (0.085 µm) bi-layer antireflective coating was deposited by e-beam evaporation.

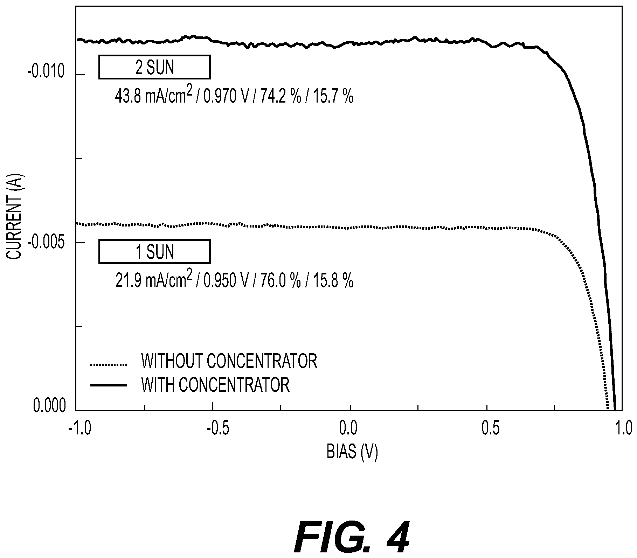

The fourth quadrant current-voltage (I-V) characteristics of the ND-ELO processed GaAs solar cell with and without a plastic mini-CPC, measured under simulated Atmospheric Mass 1.5 Global (AM 1.5G) illumination at 100 mW/cm² intensity, is presented in **Fig. 4****.** The optical power intensity was calibrated using a National Renewable Energy Laboratory traceable Si reference photovoltaic cell. The short circuit current density is 21.9 mA/cm², and the open circuit voltage is 0.95 V, the fill factor is 76%, resulting in a power conversion efficiency of 15.8% without the CPC.

The CPC was designed with 1:3 ratio of device and opening area by truncating the 50% height of the 20° tilted parabola. The 20° CPC provides the same concentration factor over a 40° acceptance angle. The GaAs thin film solar cell integrated with the CPC shows twice the short circuit current compared with the same cell without the concentrator, therefore leading to double the power generation, as shown in **Fig. 4****.**

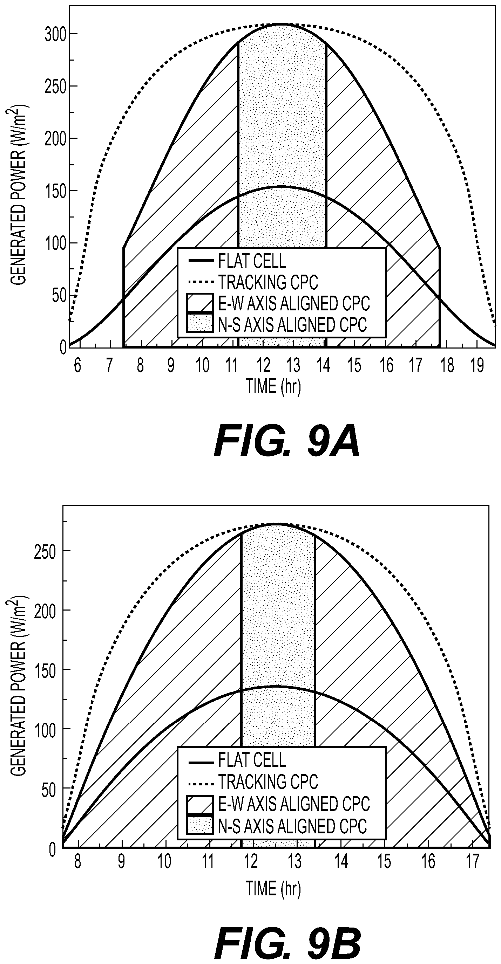

**Figs. 9(a)** and **9(b)** show comparisons of power generation from thin film GaAs photovoltaic cells made according to this example, with and without concentrator tracking as a function of seasonal conditions (January 1st and July 15th). These comparisons are calculated based on the coordinates of Phoenix, Arizona (33.4N, 112.1 W). Solar radiation intensity is calculated as a function of time using time dependent zenith angles and air mass. Diffused light is not considered for the calculation.

Energy harvesting values are then calculated by integrating the power incident on each device as a function of time throughout the course of one day. First, the power generated from a non-tracking tilted solar cell was compared with and without CPC integration. Both cases have the cells pointed with a 7.6° north and 67.75° south zenith angle for summer, and winter, respectively.

The GaAs thin film solar cell with CPC aligned with a north-south axis only collects 68% and 50% of the radiation compared with tilted flat solar cell for summer and winter, respectively. This is because of the limited acceptance angle of the CPC. On the other hand, tilted GaAs thin film solar cells with the CPC aligned along an east-west axis generates 1.9 and 2 times more power compared with a tilted flat cell for summer and winter, respectively. This is mainly due to alignment between the mini CPC coverage and the solar path. If the cell with the mini CPC tracks the sunlight, the concentration factors are even further enhanced to 2.72 and 2.33 times compared with a flat GaAs solar cell of equal area for summer and winter, respectively.

## Claims

1. A method for integrating a thin-film solar cell with non-tracking mini-concentrators, said method comprising:
providing a growth substrate;
depositing at least one protection layer on the growth substrate;
depositing at least one sacrificial layer (120) on the at least one protection layer;
depositing a photoactive cell on the sacrificial layer (120), wherein the photoactive cell is inverted;
forming a patterned metal layer comprising an array of mesas (110) on the photoactive cell by a photolithography method, wherein the mesas (110) are separated by two or more parallel trenches that extend through the patterned metal layer and the photoactive cell to the sacrificial layer;
bonding the patterned metal layer to a metallized surface of a plastic sheet (125);
etching the sacrificial layer with one or more etch steps that remove the photoactive cell from the growth substrate to form thin film solar cells bonded to the plastic sheet;
dicing the thin film solar cells bonded to the plastic sheet using laser (170);
fabricating compound parabolic concentrators (160) from a plastic material using at least one thermoforming process; and
transferring the thin film solar cells onto the thermoformed compound parabolic concentrators by an adhesive-free bonding step to form an integrated thin-film solar cell and compound parabolic concentrator (190).

2. The method of claim 1, wherein the growth substrate comprises GaAs or InP.

3. The method of claim 1, wherein the at least one protection layer is lattice matched with the growth substrate; optionally
wherein the at least one protection layer is selected from AlAs, GaAs, InP, InGaAs, AllnP, GalnP, InAs, InSb, GaP, AlP, GaSb, AlSb, and combinations thereof.

4. The method of claim 1, wherein at least one of the protection layer, sacrificial layer (120), or photoactive cell is deposited by at least one process chosen from gas source molecular beam epitaxy (GSMBE), metallo-organic chemical vapor deposition (MOCVD), hydride vapor phase epitaxy (HVPE), solid source molecular beam epitaxy (SSMBE), and chemical beam epitaxy; or
wherein the at least one protection layer comprises a buffer layer, an etch-stop layer, or combinations thereof.

5. The method of claim 1, wherein said photolithography method comprises depositing a metal layer on the photoactive cell; depositing a mask on top of the metal layer for mesa (110) etching; and performing at least one etch step through said mask to form the mesas (110) separated by the two or more parallel trenches.

6. The method of claim 1, wherein the sacrificial layer comprises AlAs, and the one or more etch steps comprise contacting said AlAs with HF.

7. The method of claim 5, wherein the at least one etch step comprises etching the metal layer and the photoactive cell with a wet etchant, a dry etchant, or combinations thereof; optionally
wherein said wet etchant comprises HF, H₃PO₄, HCl, H₂SO₄, H₂O₂, HNO₃, C₆H₈O₇, and combinations thereof, including combinations with H₂O, or
wherein said dry etchant comprises reactive ion etching (RIE) with a plasma.

8. The method of claim 1, wherein the two or more parallel trenches have a width ranging from 100 µm to 500 µm or
wherein the at least one solar cell comprises a single junction or multi-junction cell.

9. The method of claim 1, wherein the step of bonding the patterned metal layer to the plastic sheet comprises a direct attachment method selected from cold-welding, thermally assisted cold-welding, or thermo-compression bonding; or
wherein the laser is a CO₂ laser.

10. The method of claim 1, wherein said transferring of the thin film solar cells onto the thermoformed compound parabolic concentrators comprises attaching the thin-film solar cells to an elastomeric stamp and transfer printing the solar cells onto a metallized surface of the compound parabolic concentrators; optionally
wherein the metalized surface of the compound parabolic concentrators comprises at least one metal chosen from Au, Ag, Pt, Pd, Ni, and Cu.

11. The method of claim 1, wherein the plastic parabolic concentrator has a glass transition temperature below 100 °C; or
wherein the plastic parabolic concentrator comprises polyethylene terephthalate glycol-modified; or
wherein the at least one thermoforming process comprises mounting the plastic material on a negative compound-parabola shaped vacuum mold.

12. The method of claim 11, wherein a vacuum is used to pull the plastic material to the surface of the mold, to conform the plastic material to shape of the mold while the plastic material is heated above its glass transition temperature.

13. The method of claim 11, wherein the plastic material is subsequently cooled to room temperature where it holds its shape as a compound parabola; optionally wherein the plastic material that is the shape as a compound parabola is coated with at least one wetting layer and at least one metal reflecting layer; optionally
wherein the at least one wetting layer comprises Ge, or
wherein the at least one metal reflecting layer comprises Ag, or
wherein the at least one wetting layer and at least one metal reflecting layer are deposited using electron-beam, thermal evaporation or combinations thereof.

14. The method of claim 1 , wherein the compound parabolic concentrator comprises two parabolas tilted at an angle equal to the acceptance angle of the compound parabolic concentrator,
wherein the compound parabolic concentrator is truncated, and
wherein the solar cell is able to collect light at angles broader than the acceptance angle of the compound parabolic concentrator.

15. The method of claim 14, wherein the compound parabolic concentrator is designed such that the line of focal point is located right at the center of the concentrator opening plane; or
wherein the at least one photoactive cell comprises a single junction or multi-junction cell; or
wherein the compound parabolic concentrator has at least one surface that is metallized with at least one metal chosen from Au, Ag, Pt, Pd, Ni, and Cu; or
wherein the compound parabolic concentrator has a glass transition temperature below 100 °C; or
wherein the compound parabolic concentrator comprises polyethylene terephthalate glycol-modified.

## Patentansprüche

1. Verfahren zum Integrieren einer Dünnschicht-Solarzelle mit Minikonzentratoren ohne Nachführung, wobei das Verfahren folgendes umfasst:
Bereitstellen eines Wachstumssubstrats;
Abscheiden mindestens einer Schutzschicht auf das Wachstumssubstrat;
Abscheiden mindestens einer Opferschicht (120) auf die mindestens eine Schutzschicht;
Abscheiden einer fotoaktiven Zelle auf die Opferschicht (120), wobei die fotoaktive Zelle invertiert ist;
Bilden einer strukturierten Metallschicht, die eine Anordnung von Mesas (110) auf der fotoaktiven Zelle umfasst, durch ein fotolithografisches Verfahren, wobei die Mesas (110) durch zwei oder mehr parallele Gräben getrennt sind, die sich durch die strukturierte Metallschicht und die fotoaktive Zelle zu der Opferschicht erstrecken;
Bonden der strukturierten Metallschicht an eine metallisierte Oberfläche einer Kunststoffbahn (125);
Ätzen der Opferschicht mit einem oder mehreren Ätzschritten, um die fotoaktive Zelle von dem Wachstumssubstrat zu entfernen, so dass mit der Kunststoffbahn gefügte Dünnschicht-Solarzellen gebildet werden;
Vereinzeln der mit der Kunststoffbahn gefügten Dünnschicht-Solarzellen unter Verwendung eines Lasers (170);
Herstellen von parabolischen Lichtsammellinsen (160) aus einem Kunststoff unter Verwendung mindestens eines Thermoformprozesses; und
Übertragen der Dünnschicht-Solarzellen durch einen Bonding-Schritt ohne Haftmittel auf die thermogeformten parabolischen Lichtsammellinsen, so dass ein integrierter Dünnschicht-Solarzelle und parabolische Lichtsammellinse (190) gebildet wird.

2. Verfahren nach Anspruch 1, wobei das Wachstumssubstrat GaAs oder InP umfasst.

3. Verfahren nach Anspruch 1, wobei eine Gitteranpassung der mindestens einen Schutzschicht mit dem Wachstumssubstrat vorgenommen wird; wobei die mindestens eine Schutzschicht optional ausgewählt ist aus AlAs, GaAs, InP, InGaAs, AllnP, GalnP, InAs, InSb, GaP, AlP, GaSb, AlSb und Kombinationen davon.

4. Verfahren nach Anspruch 1, wobei mindestens eines der Schutzschicht, der Opferschicht (120) oder der fotoaktiven Zelle durch mindestens einen Prozess abgeschieden wird, der ausgewählt ist aus Gasquellen-Molekularstrahlepitaxie (GSMBE), metallorganischer chemischer Gasphasenabscheidung (MOCVD), Hybridgasphasenepitaxie (HVPE), Feststoffquellen-Molekularstrahlepitaxie (SSMBE) und chemischer Strahlenepitaxie; oder
wobei die mindestens eine Schutzschicht eine Pufferschicht, eine Ätzstoppschicht oder Kombinationen davon umfasst.

5. Verfahren nach Anspruch 1, wobei das fotolithografische Verfahren das Abscheiden einer Metallschicht auf die fotoaktive Zelle umfasst; das Abscheiden einer Maske auf die Metallschicht zum Ätzen von Mesas (110); und das Durchführen mindestens eines Ätzschrittes durch die Maske zur Bildung der Mesas (110), getrennt durch zwei oder mehr parallele Gräben.

6. Verfahren nach Anspruch 1, wobei die Opferschicht AlAs umfasst, und wobei der eine oder die mehreren Ätzschritte das Inkontaktbringen von AlAs mit HF umfassen.

7. Verfahren nach Anspruch 5, wobei der mindestens eine Ätzschritt das Ätzen der Metallschicht und der fotoaktiven Zelle mit einem feuchten Ätzmittel, einem trockenen Ätzmittel oder Kombinationen davon umfasst;
wobei das feuchte Ätzmittel optional HF, H₃PO₄, HCl, H₂SO₄, H₂O₂, HNO₃, C₆H₈O₇ und Kombinationen davon umfasst, darunter Kombinationen mit H₂O, oder
wobei das trockene Ätzmittel reaktives lonenätzen (RIE) mit einem Plasma umfasst.

8. Verfahren nach Anspruch 1, wobei die zwei oder mehr parallelen Gräben eine Breite von 100 µm bis 500 µm aufweisen, oder
wobei die mindestens eine Solarzelle eine einzelne Solarzelle oder eine Tandem-Solarzelle umfasst.

9. Verfahren nach Anspruch 1, wobei der Schritt des Bondens der strukturierten Metallschicht mit der Kunststoffbahn ein direktes Anbringungsverfahren umfasst, das ausgewählt ist aus Kaltschweißen, thermisch unterstütztem Kaltschweißen oder Thermokompressionsbonden; oder
wobei der Laser ein CO₂-Laser ist.

10. Verfahren nach Anspruch 1, wobei das Übertragen der Dünnschicht-Solarzellen auf die thermogeformten parabolischen Lichtsammellinsen das Anbringen der Dünnschicht-Solarzellen an einem elastomeren Stempel umfasst sowie das Transferdrucken der Solarzellen auf eine metallisierte Oberfläche der parabolischen Lichtsammellinsen;
wobei die metallisierte Oberfläche der parabolischen Lichtsammellinsen optional mindestens ein Metall umfasst, das ausgewählt ist aus Au, Ag, Pt, Pd, Ni und Cu.

11. Verfahren nach Anspruch 1, wobei die parabolische Lichtsammellinse aus Kunststoff eine Glasübergangstemperatur von unter 100 °C aufweist; oder
wobei die parabolische Lichtsammellinse aus Kunststoff mit Glycol modifiziertes Polyethylenterephthalat umfasst; oder
wobei der mindestens eine Thermoformprozess das Anbringen des Kunststoffs auf einer negativen parabelkörperförmigen Vakuumform.

12. Verfahren nach Anspruch 11, wobei ein Vakuum verwendet wird, um den Kunststoff zu der Oberfläche der Form zu ziehen, um die Form des Kunststoffs an die Form der Form anzupassen, während der Kunststoff über dessen Glasübergangstemperatur erhitzt wird.

13. Verfahren nach Anspruch 11, wobei der Kunststoff in der Folge auf Raumtemperatur abgekühlt wird, auf welcher er seine Form als Parabelkörper hält; wobei optional der Kunststoff, der die Form eines Parabelkörpers aufweist, mit mindestens einer Benetzungsschicht und mindestens einer Metallreflexionsschicht überzogen wird; wobei optional
die mindestens eine Benetzungsschicht Ge umfasst; oder
die mindestens eine Metallreflexionsschicht Ag umfasst; oder
die mindestens eine Benetzungsschicht und die mindestens eine Metallreflexionsschicht unter Verwendung von Elektronenstrahl- oder thermischer Verdampfung oder Kombinationen davon abgeschieden werden.

14. Verfahren nach Anspruch 1, wobei die parabolische Lichtsammellinse zwei Parabeln umfasst, die in einem Winkel geneigt sind, der dem Akzeptanzwinkel der parabolischen Lichtsammellinse entspricht;
wobei die parabolische Lichtsammellinse kegelstumpfförmig ist; und
wobei die Solarzelle Licht in breiteren Winkeln als der Akzeptanzwinkel der parabolischen Lichtsammellinse einfangen kann.

15. Verfahren nach Anspruch 14, wobei die parabolische Lichtsammellinse so gestaltet ist, dass sich die Fokallinie direkt in der Mitte der Öffnungsebene des Sammellinse befindet; oder
wobei die mindestens eine fotoaktive Zelle eine einzelne Solarzelle oder eine Tandem-Solarzelle umfasst; oder
wobei die parabolische Lichtsammellinse mindestens eine Oberfläche aufweist, die mit mindestens einem Metall metallisiert ist, das ausgewählt ist aus Au, Ag, Pt, Pd, Ni und Cu; oder
wobei die parabolische Lichtsammellinse eine Glasübergangstemperatur von unter 100 °C aufweist; oder
wobei die parabolische Lichtsammellinse mit Glycol modifiziertes Polyethylenterephthalat umfasst.

## Revendications

1. Méthode d'intégration d'une cellule solaire à couche mince avec des mini-concentrateurs sans poursuite, ladite méthode comprenant :
la mise en place d'un substrat de croissance ;
le dépôt d'au moins une couche de protection sur le substrat de croissance ;
le dépôt d'au moins une couche sacrificielle (120) sur l'au moins une couche de protection ;
le dépôt d'une cellule photo-active sur la couche sacrificielle (120), la cellule photo-active étant inversée ;
la formation d'une couche métallique structurée comprenant un réseau de mesa (110) sur la cellule photo-active par une méthode de photolithographie, les mesa (110) étant séparées par deux ou plusieurs sillons parallèles traversant la couche métallique structurée et la cellule photo-active jusqu'à la couche sacrificielle ;
la liaison de la couche métallique structurée à une surface métallisée d'une feuille de matière plastique (125) ;
la gravure de la couche sacrificielle avec une ou plusieurs étapes enlevant la cellule photo-active du substrat de croissance pour former des cellules solaires à couche mince liées à la feuille de matière plastique ;
le découpage des cellules solaires à couche mince liées à la feuille de matière plastique à l'aide d'un laser (170) ;
la fabrication de concentrateurs paraboliques composés (160) à partir d'une matière plastique, en utilisant au moins un procédé de thermoformage ; et
le transfert des cellules solaires à couche mince aux concentrateurs paraboliques composés thermoformés par une étape de collage sans adhésif pour former un ensemble intégré de cellule solaire à couche mince et concentrateur parabolique composé (190).

2. Méthode selon la revendication 1, le substrat de croissance comprenant GaAs ou InP.

3. Méthode selon la revendication 1, l'au moins une couche de protection étant en accord de maille avec le substrat de croissance ;
en option l'au moins une couche de protection étant sélectionnée parmi AIAs, GaAs, InP, InGaAs, AIInP, GaInP, InAs, InSb, GaP, AlP, GaSb, AISb, et une combinaison de ces derniers.

4. Méthode selon la revendication 1, l'au moins une couche de protection, la couche sacrificielle (120), ou la cellule photo-active étant déposées à l'aide d'au moins un procédé parmi les suivants : épitaxie par jets moléculaires à source gazeuse (GSMBE), dépôt chimique métallo-organique en phase vapeur (MOCVD), épitaxie en phase vapeur d'hydrure (HVPE), épitaxie par jets moléculaires à source solide (SSMBE), et épitaxie par jet chimique ; ou
l'au moins une couche de protection comprenant une couche tampon, une couche d'arrêt de gravure, ou des combinaisons de ces dernières.

5. Méthode selon la revendication 1, ladite méthode de photolithographie comprenant le dépôt d'une couche métallique sur la cellule photo-active ; le dépôt d'un masque sur le dessus de la couche métallique pour la gravure de mesa (110) ; et l'exécution d'au moins une étape de gravure à travers ledit masque pour former les mesa (110) séparées par les deux ou plusieurs sillons parallèles.

6. Méthode selon la revendication 1, la couche sacrificielle comprenant des AIA, et l'une ou plusieurs étapes de gravure comprenant la mise en contact desdits AIA avec HF.

7. Méthode selon la revendication 5, l'au moins une étape de gravure comprenant la gravure de la couche métallique et de la couche photo-active avec un agent de gravure humide, un agent de gravure sec, ou une combinaison de ces derniers ;
en option ledit agent de gravure humide comprenant HF, H₃PO₄, HCl, H₂SO₄, H₂O₂, HNO₃, C₆H₈O₇, et des combinaisons de ces derniers, y compris des combinaisons avec H₂O, ou
ledit agent de gravure sec comprenant une gravure ionique réactive (RIE) avec un plasma.

8. Méthode selon la revendication 1, les deux ou plusieurs sillons parallèles mesurant de 100 µm à 500 µm de large, ou
l'au moins une cellule solaire comprenant une cellule à jonction unique ou multiple.

9. Méthode selon la revendication 1, l'étape de liaison de la couche métallique structurée à la surface métallisée d'une feuille de matière plastique comprenant une méthode de fixation directe sélectionnée parmi le soudage à froid, le soudage à froid assisté thermiquement, ou la liaison à thermo-compression ; ou
le laser étant un laser au CO₂.

10. Méthode selon la revendication 1, ledit transfert des cellules solaires à couche mince sur les concentrateurs paraboliques composés thermoformés comprenant la fixation des cellules solaires à couche mince sur une matrice élastomère et le transfert de l'impression des cellules solaires sur une surface métallisée des concentrateurs paraboliques composés ;
en option la surface métallisée des concentrateurs paraboliques composés comprenant au moins un métal choisi parmi les suivants : Au, Ag, Pt, Pd, Ni, et Cu.

11. Méthode selon la revendication 1, le concentrateur parabolique plastique présentant une température de transition vitreuse inférieure à 100°C ; ou
le concentrateur parabolique plastique comprenant du polyéthylène téréphthalate glycol modifié ; ou
l'au moins un procédé de thermoformage comprenant le montage de la matière plastique sur un moule à vide à forme de parabole composée négative.

12. Méthode selon la revendication 11, un vide étant utilisé pour tirer la matière plastique sur la surface du moule, pour conformer la matière plastique à la forme du moule pendant le réchauffement de la matière plastique à une température supérieure à sa température de transition vitreuse.

13. Méthode selon la revendication 11, la matière plastique étant refroidie ensuite à la température ambiante, où elle maintient sa forme de parabole composée ;
en option la matière plastique ayant la forme d'une parabole composée étant revêtue d'au moins une couche de mouillage et d'au moins une couche réfléchissante métallique ;
en option l'au moins une couche de mouillage comprenant du Ge, ou
l'au moins une couche réfléchissante métallique comprenant de l'Ag, ou
l'au moins une couche de mouillage et l'au moins une couche réfléchissante métallique étant déposées par faisceau électronique, évaporation thermique, ou des combinaisons de ces derniers.

14. Méthode selon la revendication 1, le concentrateur parabolique composé comprenant deux paraboles inclinées à un angle égal à l'angle d'admission du concentrateur parabolique composé,
le concentrateur parabolique composé étant tronconique, et
la cellule solaire étant en mesure de capter de la lumière à des angles plus larges que l'angle d'admission du concentrateur parabolique composé.

15. Méthode selon la revendication 14, le concentrateur parabolique composé étant conçu de sorte que la ligne du point focal est située au centre même du plan d'ouverture du concentrateur ; ou
l'au moins une cellule photo-active comprenant une cellule à jonction unique ou multiple ; ou
le concentrateur parabolique composé possédant au moins une surface métallisée avec au moins un métal choisi parmi les suivants : Au, Ag, Pt, Pd, Ni, et Cu ; ou
le concentrateur parabolique plastique présentant une température de transition vitreuse inférieure à 100°C ; ou
le concentrateur parabolique plastique comprenant du polyéthylène téréphthalate glycol modifié.
